Europäisches Patentamt

**European Patent Office**

**Office européen des brevets**

(11) Numéro de publication: **0 334 714 B1**

# FASCICULE DE BREVET EUROPEEN

(45) Date de publication de fascicule du brevet: **16.06.93** (51) Int. Cl.5: **H03M 3/02**

(21) Numéro de dépôt: **89400702.0**

(22) Date de dépôt: **14.03.89**

(54) **Codeur différentiel à filtre prédicteur auto adaptatif et décodeur utilisable en liaison avec un tel codeur.**

(30) Priorité: **14.03.88 FR 8803288**

(43) Date de publication de la demande:
**27.09.89 Bulletin 89/39**

(45) Mention de la délivrance du brevet:
**16.06.93 Bulletin 93/24**

(84) Etats contractants désignés:
**DE GB IT NL SE**

(56) Documents cités:
**FR-A- 2 445 660**
**GB-A- 2 159 674**
**US-A- 4 411 003**

**ELCTRONIOUE INDUSTRIELLE, no. 53, 15 mai
1983, pages 43-47, Paris, FR;
J.B.ARCHINARD: "Pour le traitement de la
parole: la modulation delta"**

(73) Titulaire: **FRANCE TELECOM
6, Place d'Alleray
F-75015 Paris(FR)**

(72) Inventeur: **Zurcher Frédéric
10 Rue du Dauphiné
F-22300 Lannion(FR)**

(74) Mandataire: **Fréchède, Michel et al
Cabinet Plasseraud 84, rue d'Amsterdam
F-75009 Paris (FR)**

Rank Xerox (UK) Business Services
(3.10/3.6/3.3.1)

## Description

L'invention concerne les codeurs différentiels à filtre prédicteur auto-adaptatif et elle trouve une application particulièrement importante, bien que non exclusive, dans le domaine de la téléphonie où l'on recherche à la fois une bonne qualité de reproduction de la parole pour un débit en ligne le plus faible possible (par exemple 16 kbits/s) et une bonne résistance aux erreurs de transmission.

On connaît déjà divers codeurs utilisés à ce débit, notamment des vocodeurs à excitation impulsionnelle et des codeurs à sous-bandes. Ces codeurs sont complexes. De plus, ils introduisent des retards de plusieurs dizaines de millisecondes. On connaît également (FR-A-2 445 660) un codeur MICDA ayant un filtre prédicteur et un filtre analyseur, donc complexe.

Ce document décrit l'utilisation d'un filtre prédicteur comportant plusieurs voies en parallèle affectées à des bandes spectrales différentes adjacentes dans un codeur différentiel.

L'invention vise notamment à fournir un codeur différentiel de qualité au moins comparable à ceux connus, ayant une complexité d'implantation bien moindre.

L'invention concerne en conséquence un codeur différentiel à filtre prédicteur auto-adaptatif du type comprenant un comparateur destiné à recevoir, sur une entrée additive, le signal à coder et, sur une entrée soustractive, un signal estimé fourni par une boucle de prédiction qui reçoit le signal d'erreur provenant de la sortie du comparateur, la boucle de prédiction comprenant le filtre prédicteur auto-adaptatif, un circuit d'adaptation automatique de gain et un multiplieur qui reçoit les sorties du filtre prédictif et du circuit de calcul et dont la sortie est reliée à l'entrée soustractive.

Les codeurs temporels actuels entrant dans la catégorie des codeurs du type ci-dessus défini ne permettent pas d'obtenir une parole décodée de qualité téléphonique à un débit de l'ordre de 16 kbits/s et sont donc moins satisfaisants. L'invention vise notamment à fournir un codeur différentiel auto-adaptatif du type ci-dessus défini répondant mieux que ceux antérieurement connus aux exigences de la pratique, notamment en ce qu'il a une qualité très supérieure sans pour autant que sa complexité soit notablement accrue.

Dans ce but, l'invention propose notamment un codeur dont le filtre prédicteur comporte plusieurs voies en parallèle affectées à des bandes spectrales différentes et adjacentes, chaque voie comprenant un filtre de bande d'entrée qui alimente un détecteur quadratique suivi d'un détecteur de crête dont la sortie est appliquée à un multiplieur qui reçoit également le signal de sortie du filtre de bande, les sorties de tous les multiplieurs attaquant un même sommateur.

Dans ce codeur, le montage du filtre prédicteur est tel qu'il fait également fonction de filtre analyseur, ce qui réduit considérablement la complexité. Le signal d'entrée ayant une énergie constante (c'est-à-dire n'étant pas affecté par le gain), il n'y a pas de variation de précision du calcul.

Le filtre prédicteur permet de renforcer la dynamique spectrale dans les zones où cela est nécessaire, grâce à un choix approprié de la largeur des filtres de bande adjacents.

Un tel codeur temporel permet d'obtenir une bonne qualité téléphonique pour la parole avec un débit de sortie de 16 kbits/s. Dans un mode particulièrement avantageux de mise en oeuvre de l'invention, le codeur est d'un type fournissant un bit de sortie par échantillon. Dans cette configuration, il apparaît, vu de l'extérieur, comme un codeur Δ puisque le code transmis en ligne est constitué uniquement par le signe de l'erreur de prédiction, échantillon par échantillon. La complexité du codeur est minimum. Un autre avantage est que les signaux numériques transmis en ligne n'ont pas à être groupés en trame et qu'aucune synchronisation n'est donc nécessaire. Le codeur à un seul bit par échantillon n'introduit qu'un retard négligeable, inférieur à 300 μs dans le cas d'une transmission à 16 kbits/s. Enfin, le codeur à un seul bit par échantillon est très résistant aux erreurs de transmission.

L'invention sera mieux comprise à la lecture de la description qui suit de modes particuliers de réalisation, donnés à titre d'exemples non limitatifs. La description se réfère aux dessins qui l'accompagnent, dans lesquels :

- la figure 1 est un synoptique simplifié montrant une constitution possible de codeur fournissant un bit par échantillon et de décodeur associés suivant un premier mode de réalisation de l'invention ;
- la figure 2 est un synoptique montrant une constitution possible du filtre prédicteur auto-adaptatif du codeur de la figure 1 ;
- la figure 3 est un synoptique montrant une variante de réalisation de codeur, à plusieurs bits par échantillon, et du décodeur associé ;
- les figures 4A et 4B constituent un logigramme faisant apparaître les opérations intervenant dans le codeur de la figure 1 ;
- la figure 5 similaire à la figure 4, montre les opérations qui interviennent dans le décodeur de la figure 1.

2

## Codeur et décodeur à un seul bit en ligne par échantillon

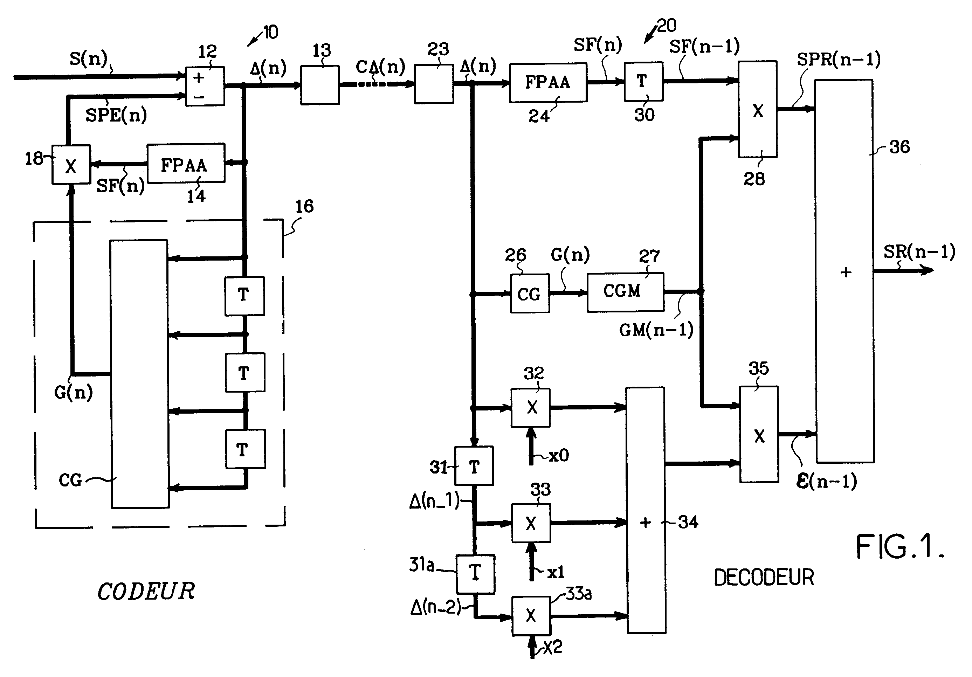

Le codeur 10 représenté en figure 1 est prévu pour fournir, en tant que signal de sortie, une séquence de codes binaires C$\Delta$(n) représentant chacun le signe d'une erreur $\Delta$(n) pouvant prendre deux valeurs +$\Delta$ et -$\Delta$ pour chaque échantillon S(n) d'ordre n.

Le codeur comprend un comparateur 12 dont la sortie prend les valeurs +$\Delta$ et -$\Delta$ suivant le signe de la différence entre l'échantillon numérique S(n) du signal à coder, appliqué sur une de ses entrées, et un échantillon prédit d'émission correspondant SPE(n) appliqué sur l'autre entrée.

Un circuit de sortie 13 du codeur transforme la séquence des signaux d'erreur $\Delta$(n) en une séquence de 0 et de 1 envoyés sur la ligne de transmission vers un décodeur et constituant les codes C$\Delta$(n).

Le circuit de génération de l'échantillon prédit SPE(n) comprend (contrairement aux codeurs $\Delta$ actuels usuels qui sont pourvus d'un filtre prédicteur fixe, ce qui ne leur permet pas de restituer une qualité téléphonique acceptable à des débits inférieurs à 32 kbits/s) : un filtre prédicteur auto-adaptatif 14 (désigné par la suite par l'abréviation FPAA) destiné à analyser le signal d'erreur $\Delta$(n) qui ne peut prendre que deux valeurs opposées, et à la restituer en renforçant sa dynamique spectrale ; un organe 16 de calcul de gain CG ; et un multiplieur 18 qui multiplie la sortie SF(n) de niveau constant du FPAA 14 par le gain G(n) pour fournir à chaque instant l'échantillon prédit d'émission SPE(n).

La constitution du décodeur 20 est dans une large mesure symétrique de celle du codeur 10. Le circuit d'entrée 23 transforme les valeurs binaires 1 et 0 arrivant par la ligne de transmission en échantillons successifs $\Delta$(n) pouvant prendre deux valeurs de même niveau, mais de polarités opposées. Le signal $\Delta$(n) attaque un FPAA 24 identique au FPAA 14 du codeur 10 et un organe 26 de calcul du gain identique à l'organe de calcul de gain CG 16. L'organe de calcul de gain moyenné lissé CGM 27 fournit, à partir des gains G(n), G(n-1) et G(n-2), un gain moyen GM(n-1) utilisé à l'instant d'échantillonnage (n-1) et égal à $\alpha 5$ G(n) + $\alpha 6$ G(n-1) + $\alpha 7$ G(n-2) avec $\alpha 5$ + $\alpha 6$ + $\alpha 7$ = 1 (ces trois coefficients peuvent notamment être égaux à 1/3). Un multiplieur 28 reçoit sur une entrée le gain à la réception GM(n-1) fourni par l'organe 27 et sur l'autre le signal filtré SF(n-1) provenant de la sortie du FPAA 24, par l'intermédiaire d'un élément de retard 30 ayant un temps de transit égal à l'intervalle temporel T entre échantillons successifs.

Un additionneur 36 reçoit le signal prédit de réception SPR(n-1) délivré par le multiplieur 28, lorsqu'arrive le code $\Delta$(n); dans le mode de réalisation montré en figure 1, il reçoit également au même instant une grandeur assimilable à un signal d'erreur de prédiction $\epsilon$(n-1) qui est une somme, pondérée par des coefficients x0 et x1, des valeurs $\Delta$(n) et $\Delta$(n-1), réalisée à partir du signal $\Delta$(n) à l'aide de l'élément de retard 31, des multiplieurs 32 et 33 et de l'additionneur 34, et multipliée par le gain GM(n-1) dans le multiplieur 35.

Le signal reconstitué SR(n-1), correspondant au signal d'entrée S(n-1) appliqué au codeur, apparaît à la sortie de l'additionneur 36.

On décrira maintenant successivement une structure de FPAA 14 ou 24 utilisable dans le dispositif de la figure 1 pour mettre en oeuvre l'invention, puis une structure de CG.

### Filtre prédicteur auto-adaptatif

Le filtre prédicteur 14 montré en figure 1 comprend I voies en parallèle, désignées par les indices 1, 2,.., i, ..., I qui attaquent un même additionneur 39, dont la sortie constitue le signal SF(n). Les échantillons $\Delta$(n) sont appliqués à l'ensemble des voies.

Dans le cas d'un filtre prédicteur 14 destiné à un codeur différentiel de téléphonie, 10 voies donnent déjà des résultats très satisfaisants ; les filtres utilisés ont dans ce cas une largeur minimale dans la partie la plus significative du spectre de parole, d'environ 250 à 400 Hz, et une largeur progressivement croissante pour les fréquences plus élevées. Un nombre plus élevé de canaux est avantageux dans la mesure où on accepte d'implémenter le FPAA sur un processeur rapide de traitement de signal.

Il est souhaitable que les bandes passantes des filtres à -3 db d'atténuation se recouvrent partiellement pour diminuer l'ondulation de la réponse totale SF(n) fournie par l'additionneur 39, dont la sortie constitue la sortie du filtre prédicteur 14.

Chaque voie comporte un filtre passe-bande d'entrée 37, qui peut être constitué par un résonateur simple du second ordre.

Diverses lois de réponse peuvent être adoptées pour les filtres 37. On peut par exemple adopter des lois de la forme :

$$SFi(n) = a0_i.\Delta(n) + a1_i.\Delta(n-1) + b1_i.SFi(n-1) + b2_i.SF_i(n-2)$$

où $a0_i$, $a1_i$, $b1_i$ et $b2_i$ sont des coefficients, différents suivant l'ordre i du filtre passe-bande. Les filtres 37 correspondent à des plages de fréquences centrées sur des valeurs croissantes F1, F2, ..., Fi, ..., FI. Les coefficients b1 et b2 déterminent la fréquence centrale et la largeur des bandes passantes. Le gain des filtres est proportionnel aux coefficients a0 et a1. Leur symétrie est déterminée par le rapport a0/a1. Les coefficients $a0_i$ et $a1_i$ sont ajustés pour minimiser la distorsion de SFi pour des signaux d'entrée (du codeur) sinusoïdaux de fréquences correspondant aux différentes fréquences centrales F1, ..., FI des filtres.

La sortie de chaque filtre, par exemple, la sortie SFi(n) pour la plage de fréquence centrée sur Fi, est appliquée à un détecteur quadratique 38, qui peut être un simple mutliplieur. Le signal détecté obtenu, $(SFi_{(n)})^2$ pour la plage de fréquences centrée sur la fréquence Fi, est appliqué à un soustracteur 40 dont l'entrée soustractive reçoit une valeur prédéterminée et constante Vi. Les valeurs V1, V2 ..., VI sont indépendantes et ajustées suivant le rang du filtre.

Le signal de sortie de chaque soustracteur 40, par exemple $[(SFi_{(n)})^2 - Vi]$, attaque un détecteur de crête 42 qui assure une fonction de lissage de l'évolution spectrale. Ce résultat peut être atteint en utilisant un détecteur 42 ayant un fonctionnement défini par les relations :

- si $SCi_n < ((SFi_{(n)})^2 - Vi)$, alors $SCi_n$ est mis au niveau $SCi_{(n-1)} + di((SFi_{(n)})^2 - Vi)$ ;
- si $SCi_{(n)} \geq ((SFi_{(n)})^2 - Vi)$ depuis plus de Mi échantillons, alors $SCi_{(n)}$ est mis au niveau $ci.(SCi_{(n-1)})$ ;
- si $SCi_{(n)} \geq ((SFi_{(n)})^2 - Vi)$ depuis moins de Mi échantillons, alors $SCi_{(n)}$ est maintenu au niveau de $SCi_{(n-1)}$.

ci et di sont des coefficients inférieurs à 1. Le nombre Mi est un entier supérieur à 1 et choisi expérimentalement en fonction des caractéristiques recherchées. On obtiendra souvent de bons résultats avec Mi prenant des valeurs croissantes avec i et comprises entre 50 et 160. Mi et les coefficients constants di et ci peuvent être différents pour les différentes voies.

Chaque voie comporte enfin un multiplieur 44 qui reçoit, pour la voie i, d'une part le signal $SFi_{(n)}$, d'autre part le signal de sortie du détecteur de crête $SCi_{(n)}$. Tous les produits obtenus sont appliqués à l'additionneur 34 qui fournit donc sur sa sortie un signal filtré :

$$SF(n) = \sum_{i=1}^{I} SFi_{(n)} \times SCi_{(n)}$$

Même si les constantes V1, ..., Vi sont négligées, on voit que les valeurs de crête des signaux $SFi_{(n)} \times SCi_{(n)}$ sont très renforcées, car proportionnel-les au cube des valeurs crête des signaux correspondants $SFi_{(n)}$. Le signal $SFE_{(n)}$ obtenu a donc une dynamique spectrale très renforcée par rapport à celle du signal $\Delta$, c'est-à-dire que les maxima sont augmentés tandis que les minima sont diminués. Comme le FPAA 14 est placé dans une boucle de contre-réaction (figure 1) ce renforcement tend à "blanchir" le signal de sortie $\Delta(n)$ c'est-à-dire à écraser le spectre du signal d'erreur. La soustraction des valeurs constantes Vi aux signaux $(SFi_{(n)})^2$ renforce encore cet effet.

Les valeurs Vi seront choisies expérimentalement. Toutefois, en règle générale, les valeurs de Vi seront d'autant plus élevées que le filtre correspond à une bande de fréquence plus haute. Il est en effet nécessaire d'augmenter la prédictibilité des fréquences élevées, naturellement moins bonne que celle des fréquences basses.

Pour faire apparaître l'effet des constantes Vi, un exemple peut être donné. Si on suppose que $SF1_{(n)}$ et $SF2_{(n)}$ ont respectivement des valeurs crête égales à 4 et 3, et si on a choisi V1 = V2 = 4, les valeurs de crête $SC1_{(n)}$ et $SC2_{(n)}$ sont 12 et 5, respectivement, et ces valeurs deviennent :
48 pour $SC1_{(n)}.SF1_{(n)}$
15 pour $SC2_{(n)}.SF2_{(n)}$
Au contraire si V1 = V2 = 0, on trouve 64 et 27 pour les facteurs $SC_{(n)}.SF_{(n)}$. On voit que la dynamique spectrale est très renforcée puisqu'elle passe de 64/27 = 2,38 à 48/15 = 3,2.

L'ensemble de tous les traitements du codeur (de même pour le décodeur) peut être réalisé à l'aide d'un processeur de traitement de signal.

Organe de calcul du gain d'émission GE

Un rôle du CG 16 est d'adapter le gain en permanence au niveau des signaux S(n). En association avec le CG 26, il doit au surplus permettre un réalignement rapide du décodeur en cas d'erreur de transmission.

Le CG 16 utilise un algorithme d'adaptation en fonction de la séquence de valeurs Δ(n) présentées successivement à son entrée. Diverses stratégies d'adaptation peuvent être adoptées. Une solution qui a donné de bons résultats consiste à utiliser les critères suivants :
- si quatre valeurs identiques sortent du comparateur 12, c'est-à-dire si on a :

$$\Delta(n) = \Delta(n-1) = \Delta(n-2) = \Delta(n-3)$$

le gain GE est "fortement" augmenté, par exemple par multiplication par un facteur $\alpha 1$ supérieur à 1 :

$$G(n) = \alpha 1.G(n-1) ;$$

- si trois valeurs identiques seulement se suivent, c'est-à-dire si on a :

$$\Delta(n) = \Delta(n-1) = \Delta(n-2) \neq \Delta(n-3)$$

le gain G est "faiblement" augmenté, par exemple par multiplication par un facteur $\alpha 2$ supérieur à 1 mais inférieur à $\alpha 1$ :

$$G(n) = \alpha 2.G(n-1) ;$$

- si trois alternances successives se produisent, c'est-à-dire si :

$$\Delta(n) \neq \Delta(n-1) \neq \Delta(n-2) \neq \Delta(n-3),$$

le gain G est "fortement" diminué, par exemple par multiplication par un coefficient $\alpha 3$ inférieur à 1 ;
- enfin, dans tous les autres cas, G est "faiblement" diminué, par exemple par multiplication par $\alpha 4$ avec $\alpha 3 < \alpha 4 < 1$.

D'autres stratégies sont possibles. Celle qui vient d'être définie exige des éléments fournissant un retard T, schématisés en figure 1.

Pour assurer un réalignement rapide à la réception en cas d'erreur de transmission, il peut être utile de donner à $\alpha 3$ une valeur égale à une constante diminuée d'un terme k.G(n-1) proportionnel à G(n-1), où k est une constante. Ainsi le coefficient $\alpha 3$ est d'autant plus petit que G(n-1) est plus grand. Si à la suite d'une erreur de transmission le gain devient plus important à la réception qu'à l'émission, il diminuera plus vite qu'à l'émission et le réalignement se fera plus rapidement.

Le décodeur 20 est prévu pour tenir compte des caractéristiques particulières du signal fourni par le codeur 10. Alors que dans un décodeur différentiel classique le signal reconstitué SR(n) est obtenu par simple addition du signal d'erreur quantifié Δ(n), restitué à partie du code CΔ(n) reçu par la ligne et du signal prédit à la réception SPR(n), l'expérience a montré qu'on augmente la qualité du signal reconstitué en ajoutant, au signal prédit SPR(n-1) correspondant au code transmis CΔ(n-1), la somme d'une fraction du signal Δ(n-1) et d'une fraction du signal Δ(n).

En conséquence, le décodeur 20 montré en figure 1, comporte, en plus de la boucle de prédiction classique (qui comporte le FPAA 24, le CG 26, le CGM 27 et le multiplieur 28) une voie supplémentaire dont la sortie est appliquée, en même temps que celle du multiplieur 28, à l'additionneur 36.

Cette voie supplémentaire comprend le multiplieur 32 qui reçoit Δ(n) et le multiplie par un facteur x0 inférieur à 1, le multiplieur 33 qui fait le produit de Δ(n-1), obtenu par l'intermédiaire d'un élément de retard 31, par un facteur x1, l'additionneur 34 qui effectue la somme (x0.Δ(n)) + (x1.Δ(n-1)) et le multiplieur 35 qui multiplie le résultat par le gain reconstitué à la réception et moyenné GM(n-1).

Le FPAA 24 est identique au FPAA 14 d'émission. Par contre, le CG 26 est complété par le CGM 27 qui peut notamment être cablé ou programmé de façon à faire intervenir des constantes $\alpha 5$, $\alpha 6$ et $\alpha 7$ et à fournir le gain reconstitué GM(n-1) par la formule :

$$GM(n-1) = \alpha 7.G(n-2) + \alpha 6.G(n-1) + \alpha 5.G(n)$$

les coefficients $\alpha$ étant choisis de façon que

$$\alpha 5 + \alpha 6 + \alpha 7 = 1$$

Ces coefficients déterminent la fonction de lissage : on peut par exemple utiliser $\alpha 5 = \alpha 7 = 0,25$ et $\alpha 6 =$

0,5.

## Codeur à plusieurs bits de sortie par échantillon

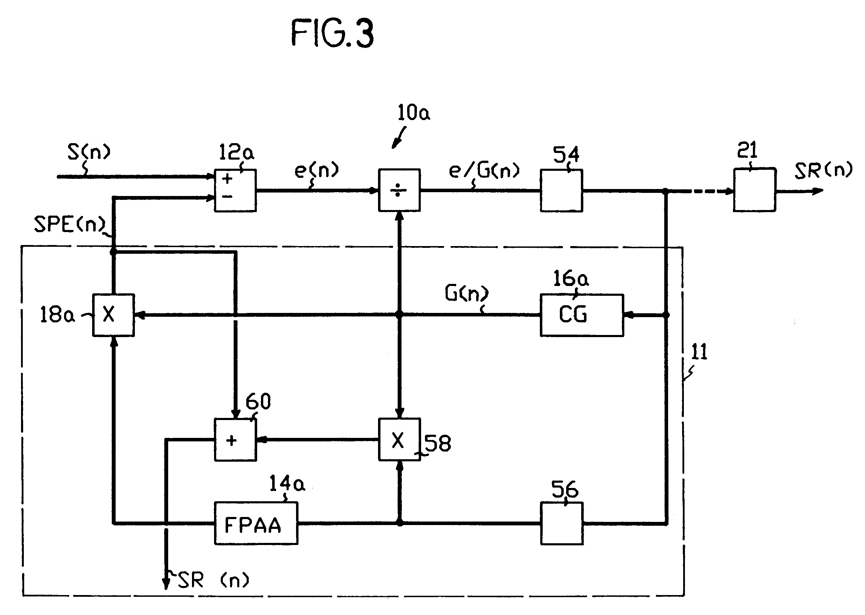

Le codeur d'émission 10a montré schématiquement en figure 3 se différencie de celui de la figure 1 en ce qu'il fournit des symboles de sortie Δ ayant plusieurs bits par échantillon d'entrée S(n).

Le signal prédit SPE(n) est cette fois retranché du signal d'entrée S(n) dans un soustracteur 12a et fournit un signal d'erreur e(n) susceptible de prendre plusieurs niveaux. Le signal d'erreur e(n) est divisé par le gain G(n), fourni de manière classique par l'organe 16a de calcul de gain en fonction des niveaux successifs fournis par un quantificateur 54 qui quantifie le résultat de la division de e(n) par G(n).

Le signal quantifié est, d'une part envoyé par la ligne de transmission vers le décodeur d'un récepteur éloigné, d'autre part envoyé à un décodeur 11 local, identique au décodeur 21 éloigné. Ce décodeur local comprend un quantificateur inverse 56 attaquant le FPAA 14a. La sortie du FPAA 14a est appliquée à un multiplieur 18a qui reçoit également la sortie de l'organe de calcul de gain d'émission 16a pour fournir le signal prédit SPE(n).

Le signal e(n)/G(n), reconstitué par quantification en 54 puis déquantification en 56, est multiplié par le gain G(n) dans un multiplieur 58, puis ajouté à SPE(n) en 60 pour obtenir le signal reconstitué à l'émission SR(n). Le FPAA 14a peut avoir une constitution similaire à celle décrite ci-dessus pour un codeur à un bit par échantillon.

Bien que les codeurs décrits présentent un intérêt particulier dans le cas d'une fréquence d'échantillonnage de 16 kHz à un bit par échantillon pour l'application à la téléphonie, elle n'est pas limitée à ce cas particulier. Le codeur de la figure 3 peut notamment fonctionner à diverses fréquences d'échantillonnage, par exemple 8 kHz, 16 kHz, etc et à différents débits, par exemple 16, 24, 32, 40 kbits/s.

De même, le codeur de la figure 1 peut fonctionner à différentes fréquences d'échantillonnage, par exemple 8, 16, 24, 32 kHz correspondant à des débit de 8, 16, 24, 32 kbits/s.

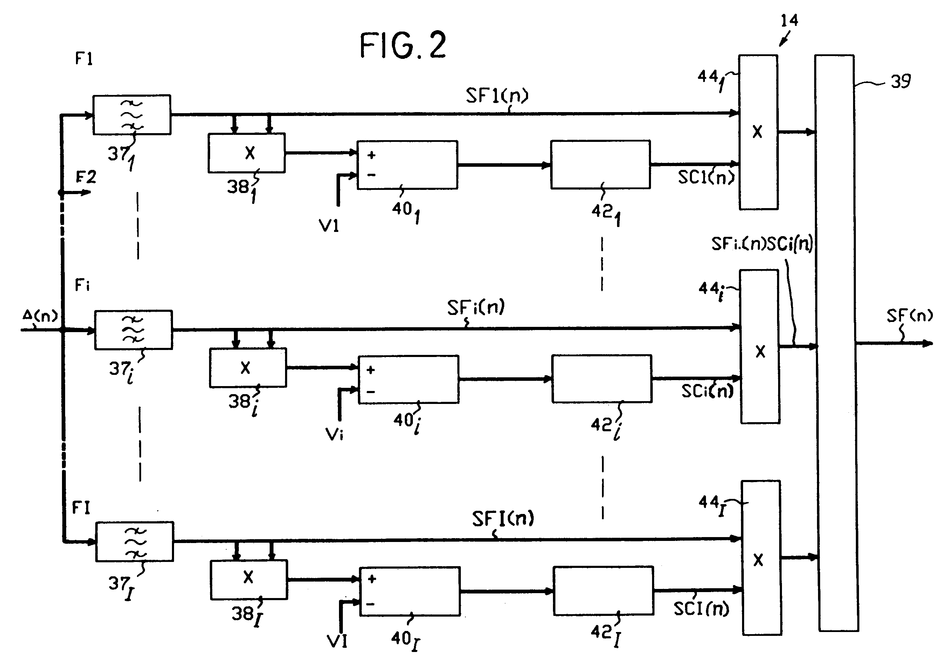

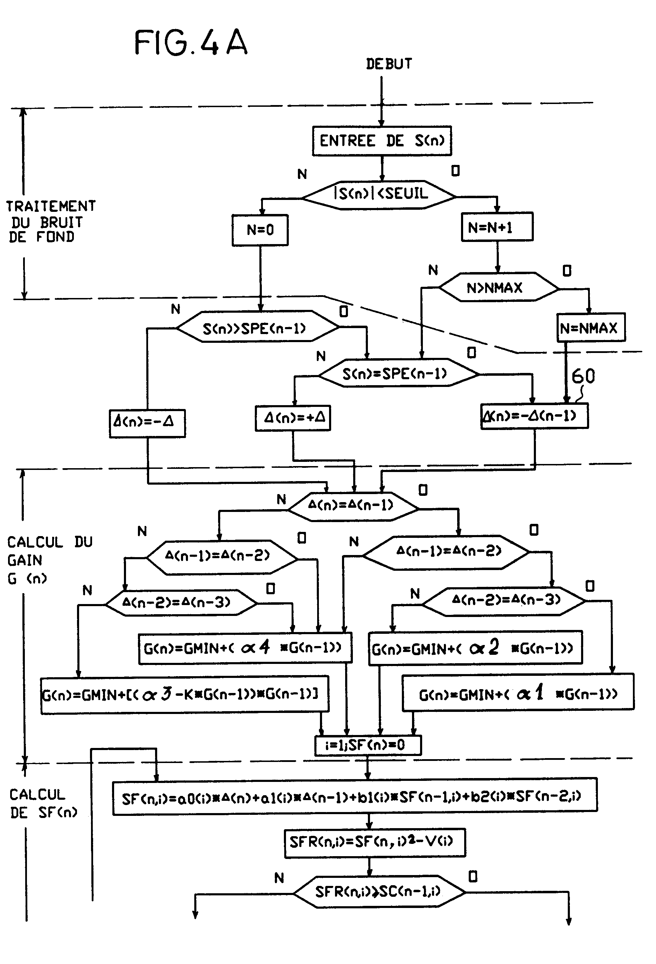

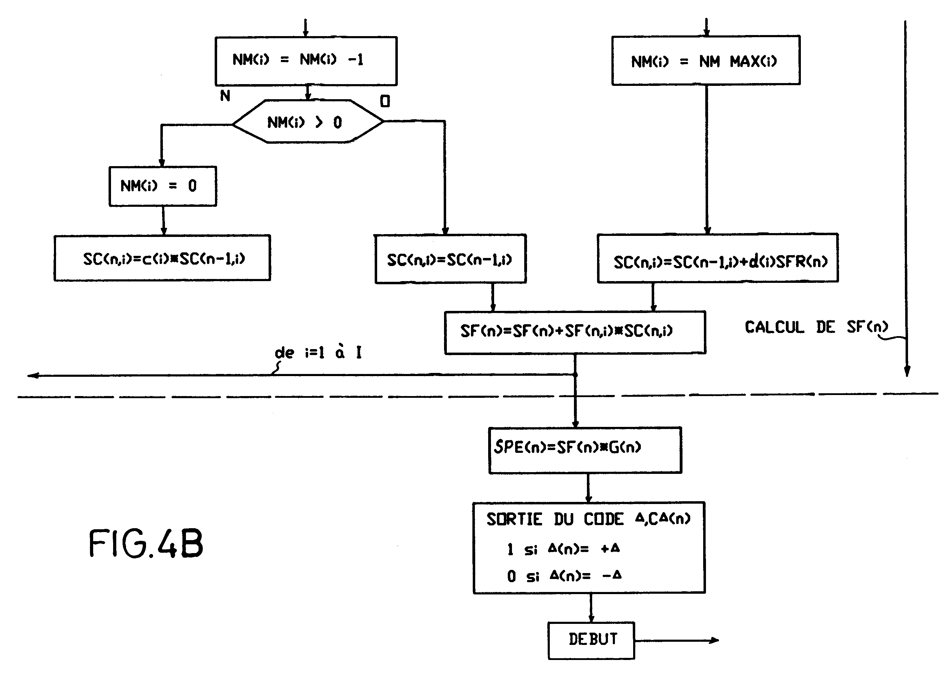

On décrira maintenant, en faisant référence à l'organigramme des figures 4A et 4B, les étapes de traitement à appliquer au signal à l'émission dans le cas d'un codeur à 1 bit par échantillon. Ces étapes correspondent, dans le cas d'implémentation à l'aide de circuits cablés, à un montage légèrement différent de celui qui apparaît sur les figures 1 et 2 et incorporent un traitement du bruit de fond qui n'est pas indispensable. L'organigramme de la figure 4 comporte ensuite les étapes de calcul du gain (correspondant à la fonction du CG 16 sur la figure 1) et de prédiction (fonction remplie par le FPAA 14 sur la figure 1).

## Traitement d'atténuation du bruit de fond

L'étape de traitement du bruit de fond montrée sur les figures 4A et 4B est avantageuse en téléphonie car elle permet de diminuer la perceptibilité du bruit de fond en cas d'utilisation de codeurs commerciaux d'entrée.

Le signal S(n), échantillonné par exemple à une fréquence de 16 kHz dans le cas de signaux téléphoniques, est soumis à un test de comparaison de ses valeurs absolues successives |S(n)| à une valeur de référence et le signal d'erreur Δ(n) est forcé à des niveaux différents suivant le résultat de ces tests. Dans le cas illustré, la valeur absolue de chaque échantillon à son tour est comparée à une valeur fixe SEUIL. Dans un mode de réalisation qui a été effectivement implémenté, NMAX a été choisi égal à 2 et la valeur SEUIL a été choisie égale au deuxième niveau à partir du plus faible que peut prendre S(n).

Si le niveau d'entrée |S(n)| est, plus de deux fois de suite,
- égal au niveau du précédent, et
- inférieur ou égal à SEUIL,
le signe de Δ(n) est inversé (bloc 60) ce qui a pour conséquence de faire tendre G(n) vers sa valeur minimum par mise en oeuvre de l'algorithme de calcul du gain.

Le traitement du bruit de fond est suivi de la comparaison entre la valeur courante du signal S(n) et la valeur prédite SPE(n-1) qui se traduit par l'envoi au codeur 13 du niveau +Δ ou -Δ.

## Calcul du gain à l'émission G(n)

Le calcul du gain s'effectue par la stratégie mentionnée plus haut, mais en utilisant pour modifier les gains des opérations plus complexes qu'une simple multiplication. Les valeurs déterminées intervenant dans le calcul et mentionnées sur la figure 4A sont :
GMIN : détermine la valeur minimale du gain

$\alpha 1$ : facteur de "forte" augmentation du gain en cas de présence de quatre signaux d'erreur $\Delta$ identiques successifs

$\alpha 2$ : facteur de "légère" augmentation du gain en cas de présence de trois signaux d'erreur $\Delta$ identiques successifs

$\alpha 3$ : facteur de "forte" diminution en cas de présence de quatre inversions successives du signal d'erreur $\Delta$

$\alpha 4$ : facteur de "légère" diminution du gain dans tous les autres cas.

Le rôle des fortes augmentation ou diminution du gain apparaît immédiatement. La "légère" augmentation du gain lorsque $\Delta$ prend trois fois de suite la même valeur permet de traiter les situations dans lesquelles il n'est pas possible de rencontrer plus de trois valeurs successives égales de $\Delta$. Ce cas peut se présenter pour des signaux qui n'ont pas de composantes marquées en dessous de 2,3 kHz alors que la fréquence d'échantillon-nage est de 16 kHz. Le facteur $\alpha 2$, qui correspond au traitement de ce cas, doit être suffisamment élevé pour permettre une perception nette des sons ayant des composantes à fréquence élevée, tels que les sons chuintants ou sifflants. Il doit cependant rester suffisamment faible pour qu'il n'y ait pas une continuelle variation du gain pendant les phases stables du signal de parole, variation qui rendrait rauque la voix à la restitution.

De bons résultats ont été obtenus en adoptant les valeurs suivantes pour les divers facteurs et coefficients :

$\alpha 1 \simeq 1,077$

$\alpha 2 \simeq 1,025$

$\alpha 3 \simeq 0,973$

$\alpha 4 \simeq 0,996$

$GMIN = 2^{-15}$

Dans l'organigramme montré en figures 4A et 4B, l'algorithme de "forte" diminution lorsqu'il y a quatre inversions successives de $\Delta$ fait intervenir, dans le facteur de multiplication de G(n-1), non seulement GDIM1 mais aussi un terme correcteur fonction de G(n-1) :

$$G(n) = GMIN + [(\alpha 3 - K^*G(n-1))^*G(n-1)]$$

Le rôle du coefficient K, qui sera toujours très inférieur à l'unité (par exemple égal à 0,012) est de permettre un alignement rapide des gains à l'émission et à la réception, où il apparaît de nouveau, en cas d'erreur de transmission.

Calcul du signal filtré à l'émission SF(n)

Au début du fonctionnement, une initialisation est effectuée par mise à zéro de SF(n).

La séquence représentée sur la figure 4B est répétée pour toutes les valeurs successives de i, à partir de i = 1 jusqu'à i = I.

Les notations suivantes sont utilisées sur l'organigramme de la figure 4B, en plus de celles déjà montrées sur la figure 2 :

NM : nombre de maintiens successifs ;

NMAX : valeur maximum prédéterminée acceptée pour NM

Les opérations successives sont celles définies pour les blocs fonctionnels sur la figure 2.

A titre d'exemple de réalisation on peut indiquer que, dans le cas où les grandeurs traitées peuvent prendre toute valeur entre -1 et $+(1-2^{-15})$, ce qui correspond à une numérisation sur 16 bits, on peut adopter pour les différentes voies les valeurs données dans le tableau I ci-dessous.

TABLEAU I

| i (n° du filtre) | Bornes à -3 dB (Hz) | ΔF | V(i) | NMAX | c(i) | d(i) |
|---|---|---|---|---|---|---|
| 1 | 250 - 600 | 350 | 0,0078 | 160 | 0,996 | 0,00244 |
| 2 | 470 - 800 | 330 | 0,0156 | 148 | 0,9956 | 0,00293 |
| 3 | 680 - 1 010 | 330 | 0,031 | 136 | 0,9954 | 0,00317 |
| 4 | 895 - 1 225 | 330 | 0,051 | 124 | 0,9951 | 0,00342 |
| 5 | 1 115 - 1 475 | 360 | 0,076 | 112 | 0,9946 | 0,00391 |
| 6 | 1 345 - 1 780 | 435 | 0,109 | 100 | 0,9941 | 0,00439 |
| 7 | 1 630 - 2 160 | 530 | 0,164 | 88 | 0,9937 | 0,00488 |
| 8 | 1 985 - 2 735 | 750 | 0,23 | 76 | 0,9929 | 0,00562 |
| 9 | 2 525 - 3 625 | 1 100 | 0,34 | 64 | 0,9922 | 0,00635 |

Le choix de NMAX est fait pour que la tension de crête SC(n) dans une voie donnée ne puisse diminuer, après avoir augmenté, qu'après passage d'un nombre d'échantillons égal à NMAX pour stabiliser l'évolution des tensions SC(n), ce qui a un effet favorable en évitant la raucité du signal reconstitué à la réception.

Les valeurs données dans le tableau I ne sont que des exemples fournis à titre indicatif. Elles correspondent au cas où neuf voies seulement sont disponibles. Dans la mesure où l'accroissement de vitesse de calcul requis par un nombre de voies accru est acceptable, un circuit de calcul de SF(n) ayant une quinzaine de voies apparaît proche de l'optimum en téléphonie. Avec quinze voies, on peut diminuer la largeur des filtres correspondant aux fréquences élevées et donc améliorer la résolution spectrale.

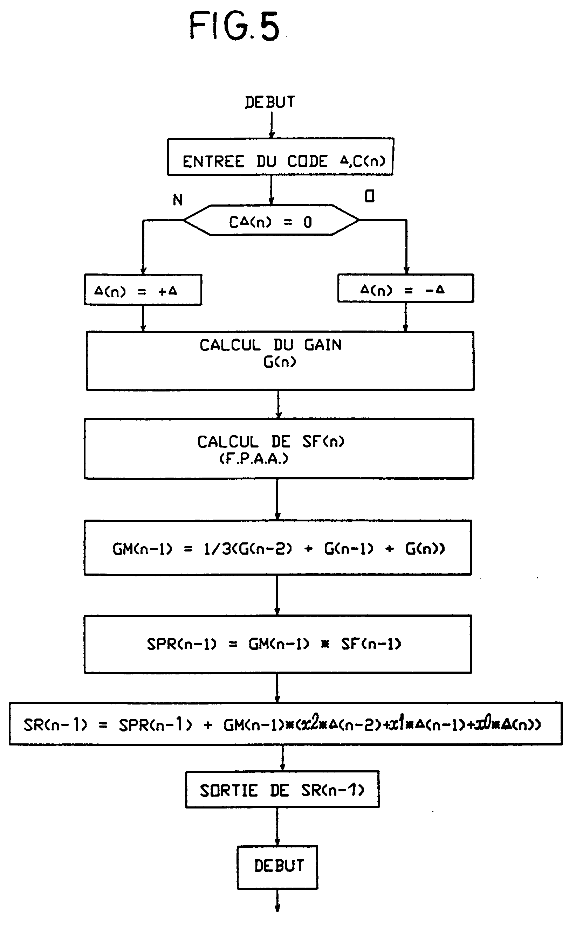

L'organigramme de réception montré en figure 5 ne répète pas le détail du calcul du gain G(n) et de SFR(n) étant donné qu'ils peuvent être identiques à ceux de la figure 4.

L'organigramme montre qu'on calcule la moyenne du gain courant G(n-1), du gain précédent G(n-2) et du gain à suivre G(n) pour chaque code CΔ de façon à lisser le gain dans les phases stationnaires tout en garantissant le maintien des pentes de variation des gains dans les phases transitoires, où le gain évolue rapidement. Dans ce dernier cas, GMIN a deux fonctions :
- il limite G(n) à une valeur minimale lorsque G(n) décroît,
- il garantit la croissance de G(n) lorsque ce dernier prend la plus petite valeur possible, compte tenu de la précision des calculs.

Une modification supplémentaire est constituée par le fait que l'on ajoute au signal prédit SPR(n-1), pour obtenir le signal reconstitué SR(n-1), trois échantillons Δ (Δ(n), Δ(n-1), Δ(n-2)) pondérés par des coefficients multiplicateurs inférieurs à 1 d'au moins deux ordres de grandeur (au lieu de deux dans le cas de l'émission).

Les valeurs des trois coefficients de pondération peuvent notamment être :

x0 = 0,00244

x1 = 0,01074

x2 = 0,01123.

Ainsi, le décodeur comprend un additionneur de sortie 36, lequel reçoit le signal prédit de réception fourni par le multiplieur 28 et trois grandeurs représentant, la première, la valeur de Δ(n) pondérée par multiplication 32 par un facteur fixe x0 et multipliée par le gain à la réception GM(n-1) fourni par l'organe de calcul de gain 26, 27, la seconde, la valeur de Δ(n-1) pondérée par multiplication (33) par un facteur fixe x1 et multipliée par le gain GM(n-1), et la troisième, la valeur de Δ(n-2) par retard 31a pondérée par multiplication 33a par un facteur fixe x2 et multipliée par le gain GM(n-1).

Tant le codeur que le décodeur décrits ci-dessus, dans la version à prédicteur comportant neuf voies en parallèle, peuvent être implémentés à l'aide d'un processeur du commerce, par exemple NEC 77 P20.

Une version à 15 ou 16 voies en parallèle est également implantable avec des processeurs de traitement de signal actuellement disponibles.

**Revendications**

1. Codeur différentiel à filtre prédicteur auto-adaptatif comprenant un comparateur (12) destiné à recevoir, sur une entrée additive, le signal à coder et, sur une entrée soustractive, un signal estimé fourni par une boucle de prédiction qui reçoit le signal d'erreur provenant de la sortie du comparateur, la boucle de prédiction comprenant un filtre prédicteur auto-adaptatif, comportant plusieurs voies en parallèle affectées à des bandes spectrales différentes et adjacentes, un circuit d'adaptation automatique de gain, caractérisé en ce que la boucle de prédiction comprend un multiplieur (18), qui reçoit les sorties du filtre prédicteur (FPAA) et du circuit d'adaptation automatique de gain, et dont la sortie est reliée à l'entrée soustractive du comparateur, et en ce que chaque voie du filtre prédicteur comprend un filtre de bande d'entrée (37i) qui alimente un détecteur quadratique (38i) suivi d'un détecteur de crête (42i) dont la sortie est appliquée à un autre multiplieur (44i) qui reçoit également le signal de sortie du filtre de bande, les sorties de tous les autres multiplieurs attaquant un même sommateur (39) dont la sortie constitue la sortie du filtre prédicteur.

**2.** Codeur différentiel selon la revendication 1, caractérisé en ce que le comparateur (12) est d'un type fournissant sur sa sortie un signal de niveau constant et pouvant avoir l'une ou l'autre de deux polarités et en ce qu'il est suivi d'un circuit (13) transformant le signal de polarités différentes en un code binaire transmis sur la ligne de façon que la sortie du codeur soit à un bit par échantillon d'entrée du signal à coder.

**3.** Codeur selon la revendication 1 ou 2, caractérisé en ce que chaque voie comprend, entre le détecteur quadratique (38i) et le détecteur de crête (42i), un circuit (40i) de soustraction, au signal de sortie du détecteur quadratique (38i), d'une valeur ajustable (Vi).

**4.** Codeur selon la revendication 3, caractérisé en ce que les valeurs ajustables (Vi) soustraites ont un niveau croissant avec le rang (1, ..., i, ..., I) du filtre de bande de façon à augmenter la prédictibilité pour les fréquences élevées.

**5.** Codeur selon l'une quelconque des revendications précédentes destiné à recevoir un signal de parole à coder, caractérisé en ce que les filtres de bandes ont des bandes de largeur croissant avec le rang du filtre ou sensiblement constante et en ce que le nombre des voies est compris entre 8 et 16.

**6.** Codeur selon l'une quelconque des revendications précédentes, caractérisé en ce que le détecteur de crête (42) fonctionne suivant l'algorithme :
- si $SCi_{(n)} < ( (SFi_{(n)})^2 - Vi )$, alors $SCi_{(n)}$ est mis au niveau $SCi_{(n-1)} + di ( (SFi_{(n)})^2 - Vi )$ ;
- si $SCi_{(n)} \geq ( (SFi_{(n)})^2 - Vi )$ depuis plus de Mi échantillons, alors $SCi_{(n)}$ est mis au niveau ci x $(SCi_{(n-1)})$ ;
- si $SCi_{(n)} \geq ( (SFi_{(n)})^2 - Vi )$ depuis moins de Mi échantillons, alors $SCi_{(n)}$ est maintenu au niveau de $SCi_{(n-1)}$,

où $SCi_{(n)}$ désigne la sortie du détecteur de crête, l'autre terme désigne le signal appliqué à son entrée, Mi désigne un nombre prédéterminé supérieur à 1, et ci et di désignent des coefficients inférieurs à l'unité.

**7.** Codeur selon l'une quelconque des revendications précédentes, caractérisé en ce que le circuit de prédiction de gain utilise l'algorithme d'adaptation, en fonction de la séquence de valeurs $\Delta(n)$ présentées successivement à son entrée, représenté par les critères suivants :
a. si quatre valeurs identiques sortent du comparateur (12), c'est-à-dire si :

$$\Delta(n) = \Delta(n-1) = \Delta(n-2) = \Delta(n-3),$$

le gain est fortement augmenté, par exemple par multiplication par un facteur $\alpha 1$ supérieur à 1 ;
b. si trois valeurs identiques seulement se suivent, c'est-à-dire si :

$$\Delta(n) = \Delta(n-1) = \Delta(n-2) \neq \Delta(n-3),$$

le gain est faiblement augmenté, par exemple par multiplication par un facteur $\alpha 2$ supérieur à 1 mais inférieur à $\alpha 1$ ;
c. si trois alternances successives se produisent, c'est-à-dire si :

$$\Delta(n) \neq \Delta(n-1) \neq \Delta(n-2) \neq \Delta(n-3),$$

le gain est fortement diminué, par exemple par multiplication par un coefficient inférieur à 1 ;
d. dans tous les autres cas, le gain est faiblement diminué, par exemple par multiplication par un coefficient $\alpha 4$ inférieur à 1 mais supérieur à $\alpha 3$.

**8.** Codeur selon la revendication 7 , caractérisé en ce que dans le cas c, le gain est diminué par multiplication par un coefficient ($\alpha 3$ - k*G(n-1)), ou $\alpha 3$ est un coefficient inférieur à 1 et k est une constante.

**9.** Décodeur utilisable en coopération avec le codeur suivant l'une quelconque des revendications précédentes, le décodeur comprenant un organe de calcul du gain de réception (26, 27) et un filtre prédicteur (24) identique au filtre prédicteur du codeur, le filtre prédicteur (24) comportant plusieurs voies en parallèle affectées à des bandes spectrales différentes et adjacentes, caractérisé en ce que chaque voie du filtre prédicteur (24) comprend un filtre de bande d'entrée (37i) qui alimente un détecteur quadratique (38i) suivi d'un détecteur de crête (42i) dont la sortie est appliquée à un multiplieur (44i) qui reçoit également le signal de sortie du filtre de bande, les sorties de tous les multiplieurs attaquant un même sommateur (39) dont la sortie constitue la sortie du filtre prédicteur (24), et qu'il est pourvu d'un autre multiplieur (28) qui reçoit, sur une entrée, le gain moyen à la réception fourni par l'organe de calcul de gain (26, 27) et, sur l'autre entrée, le signal filtré SF(n-1) provenant de la sortie du filtre prédicteur (24), par l'intermédiaire d'un élément de retard (30) ayant un temps de transit égal à l'intervalle temporel T entre échantillons successifs, ledit autre mutliplieur (28) délivrant un signal prédit de réception SPR(n-1)."

**10.** Décodeur selon la revendication 9, caractérisé en ce que le gain moyen à la réception appliqué au multiplieur (28) est de la forme GM(n-1) :

$$\alpha 5.G(n) + \alpha 6.G(n-1) + \alpha 7.G(n-2),$$

$\alpha 5$, $\alpha 6$ et $\alpha 7$ étant des coefficients prédéterminés.

**11.** Décodeur selon la revendication 9 ou 10 caractérisé en ce qu'il comprend un additionneur de sortie (36) qui reçoit le signal prédit de réception SPR(n-1) fourni par l'autre multiplieur (28) et trois grandeurs représentant :
- la première, la valeur de $\Delta(n)$ pondérée par multiplication par un facteur fixe x0 et multipliée par le gain à la réception GM(n-1), fourni par l'organe de calcul de gain (26, 27),
- la seconde, la valeur de $\Delta(n-1)$ pondérée par multiplication par un facteur fixe x1 et multipliée par le gain GM(n-1), et
- la troisième, la valeur de $\Delta(n-2)$ pondérée par multiplication par un facteur fixe x2 et multipliée par le gain GM(n-1).

**12.** Codeur selon la revendication 1, caractérisé en ce qu'il est prévu pour fournir des symboles de sortie à plusieurs bits par échantillons d'entrée et en ce qu'il comporte : un soustracteur (12a) pour retrancher le signal prédit SPE(n) du signal d'entrée S(n) et fournir un signal d'erreur e(n) à plusieurs niveaux ; des moyens pour diviser le signal d'erreur par le gain G(n) ; et un quantificateur (54) du résultat de la division.

**Claims**

**1.** Differential encoder with a self-adaptive predictive filter, comprising a comparator (12) receiving, on an additive input a signal to be encoded and, on a subtractive input, an estimated signal delivered by a prediction loop which receives the error signal from the output of the comparator, said prediction loop comprising a self-adaptive predictive filter comprising several channels parallel connected and assigned to different mutually adjacent spectral bands, a gain control circuit, characterized by said prediction loop comprising a multiplier (18) which receives the output signals of said predictive filter (FPAA) and gain control circuit, the output of said multiplier being connected to the subtractive input of said comparator, each channel of said predictive filter comprising an input pass-band filter (37i), a quadratic detector (38i) fed by said pass-band filter, and a peak detector (42i) whose input is connected to the quadratic detector and whose output is applied to another multiplier (44i) which also receives the output signal from the respective pass-band filter, the outputs of all other multipliers driving a common summer (39) the output of which forms the output of said predictive filter.

**2.** Differential encoder according to claim 1, characterized by the comparator (12) being arrenged for delivering a constant level output signal having signs plus or minus, said encoder further comprising, following said comparator, a circuit (13) receiving the output signal from the comparator and transforming said output signal into a binary code which is sent on the line, the output of the encoder having one bit per input sample of the signal to be encoded.

3. Encoder according to claim 1 or 2, wherein each of said channels further comprises a circuit (40i) for subtracting an adjustable value (Vi) from the output signal of the quadratic detector (38i), said subtracting circuit being located between the quadratic detector (38i) and the peak detector (42i).

4. Encoder according to claim 3, characterized by said adjustable value being different according to the channel order (1,..i,...I) and having a magnitude which is higher for the channels having spectral bands of higher frequencies, whereby the predictibility is enhanced for the higher frequencies.

5. Encoder according to one of the preceeding claims, adapted to receive a speech signal to be encoded, characterized by pass-band filters having band widths which are higher for the higher frequencies or have a constant width the number of channels being comprised between 8 and 16.

6. Encoder according to one of the preceeding claims, wherein the peak detector (42) is constructed to operate according to the algorithm :
   - if $SCi_{(n)} < ((SFi_{(n)})^2-Vi)$, then $SCi_{(n)}$ is adjusted at the level $SCi_{(n-1)} + di((SFi_{(n)})^2-Vi)$ ;
   - if $SCi_{(n)} > ((SFI_{(n)})^2-Vi)$ for more than Mi successive samples, then $SCi_{(n)}$ is adjusted at level ci.-$(SCi_{(n-1)})$ ;
   - if $SCi_{(n)} > ((SFi_{(n)})^2-Vi)$ for less than Mi successive samples, then $SCi_{(n)}$ is kept at level $SCI_{(n-1)}$ ;
   wherein $SCi_{(n)}$ designates the output of the peak detector, the second part of the above identified equations designates the signal applied to the input of the peak detector, Mi designates a predetermined number higher than 1 and ci and di designate coefficients smaller than 1.

7. Encoder according to one of the preceeding claims, characterized by the gain control circuit being constructed to operate according to an adaptation algorithm responsive to a sequence of values $\Delta(n)$ successively present at the input thereof, said algorithm being represented by the following criteria :
   a) if four identical values appear at the output by the comparator (12),i.e. if :

   $$\Delta(n) = \Delta(n-1) = \Delta(n-2) = \Delta(n-3)$$

   the gain is increased, by multiplying it by a factor $\alpha1$ greater than 1 ;
   b) if there are only three identical values which follow each other, i.e. if :

   $$\Delta(n) = \Delta(n-1) = \Delta(n-2) \neq \Delta(n-3)$$

   the gain is increased, by multiplying it by a factor $\alpha2$ greater than 1 but lesser than $\alpha1$ ;
   c) if three successive alternations occur, i.e. if :

   $$\Delta(n) \neq \Delta(n-1) \neq \Delta(n-2) \neq \Delta(n-3),$$

   the gain is decreased, by multiplying it by a coefficient $\alpha3$ lesser than 1 ;
   d) in all other cases, the gain is decreased, by multiplying it by a coefficient $\alpha4$, with $\alpha4$ lesser than 1 but greater than $\alpha3$.

8. Encoder according to claim 7, characterized by in case c), the gain is decreased by multiplying it by a coefficient $\alpha3-k^*G(n-1)$ where k is a constant value, $\alpha3$ being lesser than 1.

9. Decoder for use in cooperation with the encoder according one of the preceeding claims, said decoder comprising a unit (26,27) for computing the reception gain and a predictive filter (24) identical to the predictive filter of the encoder, said predictive filter (24) comprising several channels parallel connected and assigned to different mutually adjacent spectral bands, characterized by said channel of said predictive filter (24) each comprising an input pass-band filter (37i), a quadratic detector (38i) fed by said pass-band filter, and a peak detector (42i) whose input is connected to the quadratic detector and whose output is applied to another multiplier (44i) which also receives the output signal from the respective pass-band filter, the outputs of all other multipliers driving a common summer (39) the

11

EP 0 334 714 B1

output of which forms the output of said predictive filter (24), said predictive filter comprising another multiplier (28) connected to receive on one input the reception gain delivered by said unit, and on another input, the filtered signal SF(n-1) from the output of the predictive filter (24), through a delay element (30) having a transit time equal to the time interval (T) between two successive samples, said another multiplier (28) delivering a predicted reception signal SPR(n-1).

10. Decoder according to claim 9, characterized by said multiplier being arranged for providing a mean reception gain equal to

GM(n-1) = $\alpha$7.G(n-2) + $\alpha$6.G(n-1) = $\alpha$5.G(n)

$\alpha$5, $\alpha$6, $\alpha$7 designating coefficients of predetermined values.

11. Decoder according to claim 9 or 10, characterized by further comprising an output adder (36) which receives said predicted reception signal SPR(n-1) delivered by said other multiplier (28) and three values which respectively represent :
   - the value of $\Delta$(n) weighted by multiplication by a fixed coefficient x0 and mulitiplied by the reception gain GM(n-1) delivered by said computing unit (26,27) ;
   - the value of $\Delta$(n-1) weighted by multiplication by a fixed coefficient x1 and multiplied by the gain GM(n-1), and
   - the value of $\Delta$(n-2) weighted by multiplication by a fixed coefficient x2 and multiplied by the gain GM(n-1).

12. Encoder according to claim 1, characterized by being adapted for providing multibits encoded output symbols for each input sample, said encoder comprising
   - a unit (12a) for subtracting the predicted signal SPE(n) from input signal S(n) so as to generate a multilevel error signal e(n),
   - a unit for dividing the error signal through the gain value G(n), and
   - a unit (54) for quantifying the result obtained from the division result.

**Patentansprüche**

1. Differentieller Kodierer mit autoadaptivem Prädiktorfilter
   mit einem Komparator (12), der an einem additiven Eingang das zu kodierende Signal und an einem subtraktiven Eingang ein Schätzsignal aufnimmt, das von einer Prädiktionsschleife geliefert wird, die das vom Ausgang des Komparators kommende Fehlersignal aufnimmt, wobei die Prädiktionsschleife ein autoadaptives Prädiktorfilter mit mehreren parallelen Zweigen aufweist, die unterschiedlichen, aneinandergrenzenden Spektralbändern zugeordnet sind,
   sowie mit einer Schaltung zur automatischen Verstärkungsanpassung,
   **dadurch gekennzeichnet,**
   daß die Prädiktionsschleife einen Multiplizierer (19) enthält, der die Ausgangssignale des Prädiktorfilters (FPAA) und der Schaltung zur automatischen Verstärkungsanpassung aufnimmt und dessen Ausgang mit dem subtraktiven Eingang des Komparators verbunden ist,
   und daß jeder Zweig des Prädiktorfilters ein Eingangsbandfilter (37i) enthält, das einen quadratischen Detektor (38i) speist, auf den ein Spitzenwertdetektor (42i) folgt, dessen Ausgangssignal einem weiteren Multiplizierer (44i) zugeführt wird, der außerdem das Ausgangssignal des Bandfilters aufnimmt, wobei die Ausgangssignale aller dieser weiteren Multiplizierer denselben Addierer (39) beaufschlagen, dessen Ausgang den Ausgang des Prädiktorfilters bildet.

2. Differentieller Kodierer nach Anspruch 1, dadurch gekennzeichnet, daß der Komparator (12) ein Komparator des Typs ist, der an seinem Ausgang ein Signal mit konstantem Pegel liefert, das die eine oder die andere von zwei Polaritäten haben kann, und daß auf den Komparator eine Schaltung (13) folgt, die das Signal mit unterschiedlichen Polaritäten in einen Binärkode umwandelt, der in einer solchen Form über die Leitung übertragen wird, daß das Ausgangssignal des Kodierers für jede dem Eingang zugeführte Abtastprobe des zu kodierenden Signals ein 1-Bit-Signal ist.

3. Kodierer nach Anspruch 1 oder 2, dadurch gekennzeichnet, daß jeder Zweig eine zwischen dem quadratischen Detektor (38i) und dem Spitzenwertdetektor (42i) angeordnete Subtraktionsschaltung

EP 0 334 714 B1

(40i) aufweist, die von dem Ausgangssignal des quadratischen Detektors (38i) einen einstellbaren Wert (Vi) subtrahiert.

4. Kodierer nach Anspruch 3, dadurch gekennzeichnet, daß die Pegel der einstellbaren Werte (Vi) zur Vergrößerung der Vorhersagbarkeit für die höheren Frequenzen mit der Rangordnung (1, ..., i, ..., l) des Bandfilters größer werden.

5. Kodierer nach einem der vorhergehenden Ansprüche zur Aufnahme eines zu kodierenden Sprachsignals, dadurch gekennzeichnet, daß die Bandfilter eine mit der Rangordnung des Filters größer werdende oder eine im wesentlichen konstante Bandbreite haben und daß die Anzahl der Zweige zwischen acht und sechzehn liegt.

6. Kodierer nach einem der vorhergehenden Ansprüche, dadurch gekennzeichnet, daß der Spitzenwertdetektor (42) nach folgendem Algorithmus arbeitet:
   - wenn $SCi_{(n)} < [(SFi_{(n)})^2 - Vi]$ ist, wird $SCi_{(n)}$ auf den Pegel $SCi_{(n-1)} + di [(SFi_{(n)})^2 - Vi]$ gesetzt,
   - wenn seit mehr als Mi Abtastproben $SCi_{(n)} \geq [(SFi_{(n)})^2 - Vi]$ ist, wird $SCi_{(n)}$ auf den Pegel ci x $(SCi_{(n-1)})$ gesetzt,
   - wenn seit weniger als Mi Abtastproben $SCi_{(n)} \geq [(SFi_{(n)})^2 - Vi]$ ist, wird $SCi_{(n)}$ auf dem Pegel $SCi_{(n-1)}$ gehalten,

   wobei $SC_{(n)}$ das Ausgangssignal des Spitzenwertdetektors bezeichnet und der andere Ausdruck das an seinem Eingang anliegende Signal bedeutet, Mi eine vorbestimmte Zahl größer als 1 und ci und di Koeffiezenten bedeuten, die kleiner sind als die zugrunde liegende Einheit.

7. Kodierer nach einem der vorhergehenden Ansprüche, dadurch gekennzeichnet, daß die Schaltung zur Prädiktion des Verstärkungsfaktors in Abhängigkeit von der Folge der nacheinander an ihrem Eingang auftretenden Werte $\Delta(n)$ den durch folgende Kriterien gegebenen Adaptierungsalgorithmus anwendet:
   a. Falls -- der Komparator (12) vier identische Werte liefert, d.h. falls

   $$\Delta(n) = \Delta(n-1) = \Delta(n-2) = \Delta(n-3),$$

   wird der Verstärkungsfaktor stark erhöht, z.B. durch Mulktiplikation mit einem Faktor $\alpha1$, der größer ist als 1;
   b. Falls nur drei identische Werte aufeinander folgen, d.h. falls

   $$\Delta(n) = \Delta(n-1) = \Delta(n-2) \neq \Delta(n-3),$$

   wird der Verstärkungsfaktor schwach erhöht, z.B. durch Mulktiplikation mit einem Faktor $\alpha2$, der größer als 1 jedoch kleiner als $\alpha1$ ist;
   c. Falls drei Alternierungen aufeinander folgen, d.h. falls

   $$\Delta(n) \neq \Delta(n-1) \neq \Delta(n-2) \neq \Delta(n-3),$$

   wird der Verstärkungsfaktor stark herabgesetzt, z.B. durch Mulktiplikation mit einem Koeffizienten, der kleiner als 1 ist;
   d. In allen anderen Fällen wird der Verstärkungsfaktor schwach herabgesetzt, z.B. durch Mulktiplikation mit einem Koeffizienten $\alpha4$, der kleiner als 1 jedoch größer als $\alpha3$ ist.

8. Kodierer nach Anspruch 7, dadurch gekennzeichnet, daß im Fall c der Verstärkungsfaktor durch Multiplikation mit einem Koeffizienten $(\alpha3 - k^*G(n-1))$ herabgesetzt wird, worin $\alpha3$ einen Koeffizienten kleiner 1 und k eine Konstante bedeuten.

9. Dekodierer zur Verwendung in Zusammenarbeit mit einem Kodierer nach einem der vorhergehenden Ansprüche, mit einem Rechenorgan (26, 27) zur Berechnung der Empfangsverstärkung und einem mit dem Prädiktorfilter des Kodierers identischen Prädiktorfilter (24), das mehrere parallele Zweige aufweist, die unterschiedlichen, aneinandergrenzenden Spektralbändem zugeordnet sind,
   **dadurch gekennzeichnet**
   daß jeder Zweig des Prädiktorfilters (24) ein Eingangsbandfilter (37i) aufweist, das einen quadratischen Detektor (38i) speist, auf den ein Spitzenwertdetektor (42i) folgt, dessen Ausgangssignal einem

13

Multiplizierer (44i) zugeführt wird, der außerdem das Ausgangssignal des Bandfilters aufnimmt, wobei die Ausgangssignale aller Multiplizierer denselben Addierer (39) beaufschlagen, dessen Ausgang den Ausgang des Prädiktorfilters (24) bildet,

und daß ein weiterer Multiplizierer (28) vorgesehen ist, der an einem Eingang die von dem genannten Rechenorgan (26, 27) zur Berechnung der Empfangsverstärkung gelieferte mittlere Empfangsverstärkung und an dem anderen Eingang das von dem Ausgang des Prädiktorfilters (24) kommende gefilterte Signal SF(n-1) aufnimmt, das über ein Verzögerungselement (30) mit einer dem Zeitintervall T zwischen zwei aufeinanderfolgenden Abtastproben entsprechenden Verzögerungszeit geführt wird, wobei dieser weitere Multiplizierer (28) ein prädiziertes Empfangssignal SPR(n-1) liefert.

10. Dekodierer nach Anspruch 9, dadurch gekennzeichnet, daß die dem Multiplizierer (28) zugeführte mittlere Empfangsverstärkung die Form GM(n-1) hat :

$$\alpha5 \cdot G(n) \ + \ \alpha6 \cdot G(n-1) \ + \ \alpha7 \cdot G(n-2),$$

wobei $\alpha5$, $\alpha6$ und $\alpha7$ vorbestimmte Koeffizienten sind.

11. Dekodierer nach Anspruch 9 oder 10, dadurch gekennzeichnet, daß er einen Ausgangsaddierer (36) aufweist, der das von dem weiteren Multiplizierer (28) gelieferte prädizierte Empfangssignal SPR(n-1) sowie drei Größen aufnimmt, von denen
- die erste den Wert $\Delta(n)$, durch Multiplikation mit einem konstanten Faktor x0 gewichtet und mit der von dem Rechenorgan (26, 27) zur Berechnung der Verstärkung gelieferten Empfangsverstärkung GM(n-1) multipliziert,
- die zweite den Wert $\Delta(n-1)$, durch Multiplikation mit einem konstanten Faktor x1 gewichtet und mit der Verstärkung GM(n-1) multipliziert, und
- die dritte den Wert $\Delta(n-2)$, durch Multiplikation mit einem konstanten Faktor x2 gewichtet und mit der Verstärkung GM(n-1) multipliziert,
repräsentiert.

12. Kodierer nach Anspruch 1, dadurch gekennzeichnet, daß er zur Erzeugung von Ausgangssymbolen mit mehreren Bits pro Eingangs-Abtastprobe dient und folgende Teile aufweist:
- einen Subtrahierer (12a) zum Subtrahieren des prädizierten Signals SPE(n) von dem Eingangssignal S(n) und zur Lieferung eines Fehlersignals e(n) mit mehreren Pegeln,
- Mittel zum Teilen des Fehlersignals durch den Verstärkungsfaktor G(n) und
- einen Quantisierer (54) zum Quantisieren des Ergebnisses der Division.

CODEUR

DECODEUR

FIG.1.

S(n) 12 10 13 CΔ(n) 23 Δ(n) SF(n) 20 SF(n-1) SPR(n-1)

Δ(n) + / − FPAA 24 T 30 X 28 36

SPE(n)

18 X FPAA SF(n) 14

16 T T T

G(n)

CG

26 G(n) 27 CG CGM GM(n-1)

32 X 35

31 T x0 X

Δ(n_1) 33 X x1 + 34 ε(n-1)

31a T

Δ(n_2) 33a X x2

SR(n-1)

EP 0 334 714 B1

# FIG.2

EP 0 334 714 B1

# FIG.3

S(n) → [12a +/−] → e(n) → [÷ 10a] → e/G(n) → [54] → ... → [21] → SR(n)

SPE(n)

[18a X] ← G(n) ← [16a CG]

[60 +] ← [X 58]

[14a FPAA]

[56]

11

↓ SR (n)

EP 0 334 714 B1

# FIG.4A

DEBUT

ENTREE DE S(n)

TRAITEMENT
DU BRUIT
DE FOND

N |S(n)|<SEUIL □

N=0          N=N+1

N N>NMAX □

N S(n)>SPE(n-1) □          N=NMAX

N S(n)=SPE(n-1) □          60

$\Delta(n)=-\Delta$          $\Delta(n)=+\Delta$          $\Delta(n)=-\Delta(n-1)$

CALCUL DU
GAIN
G (n)

□
N $\Delta(n)=\Delta(n-1)$

N $\Delta(n-1)=\Delta(n-2)$ □          N $\Delta(n-1)=\Delta(n-2)$ □

N $\Delta(n-2)=\Delta(n-3)$ □          N $\Delta(n-2)=\Delta(n-3)$ □

$G(n)=GMIN+(\alpha 4 *G(n-1))$          $G(n)=GMIN+(\alpha 2 *G(n-1))$

$G(n)=GMIN+[(\alpha 3 -K*G(n-1))*G(n-1)]$          $G(n)=GMIN+(\alpha 1 *G(n-1))$

$i=1; SF(n)=0$

CALCUL
DE SF(n)

$SF(n,i)=a0(i)*\Delta(n)+a1(i)*\Delta(n-1)+b1(i)*SF(n-1,i)+b2(i)*SF(n-2,i)$

$SFR(n,i)=SF(n,i)^2-V(i)$

N $SFR(n,i)>SC(n-1,i)$ □

18

NM(i) = NM(i) -1

NM(i) = NM MAX(i)

NM(i) > 0    N    O

NM(i) = 0

SC(n,i)=c(i)∗SC(n-1,i)

SC(n,i)=SC(n-1,i)

SC(n,i)=SC(n-1,i)+d(i)SFR(n)

SF(n)=SF(n)+SF(n,i)∗SC(n,i)

CALCUL DE SF(n)

de i=1 à I

$SPE(n)=SF(n)*G(n)$

SORTIE DU CODE $\Delta,C\Delta(n)$

1 si $\Delta(n)= +\Delta$

0 si $\Delta(n)= -\Delta$

DEBUT

FIG.4B

EP 0 334 714 B1

# FIG.5

DEBUT

ENTREE DU CODE $\Delta,C(n)$

N $\qquad$ $C\Delta(n) = 0$ $\qquad$ O

$\Delta(n) = +\Delta$ $\qquad$ $\Delta(n) = -\Delta$

CALCUL DU GAIN
$G(n)$

CALCUL DE SF(n)
(F.P.A.A.)

$GM(n-1) = 1/3(G(n-2) + G(n-1) + G(n))$

$SPR(n-1) = GM(n-1) * SF(n-1)$

$SR(n-1) = SPR(n-1) + GM(n-1)*(x2*\Delta(n-2)+x1*\Delta(n-1)+x0*\Delta(n))$

SORTIE DE SR(n-1)

DEBUT